# EUROPEAN PATENT APPLICATION

(11) **EP 2 500 390 A1**
(43) Date of publication of application: **19.09.2012**
(21) Application number: 12159551.6
(22) Date of filing: 15.03.2012
(51) Int. Cl.: C09J 7/02, C09J 11/06, C09J 9/00

(54) **Pressure-sensitive adhesive tape for temporary fixing of electronic part**

(30) Priority: 17.03.2011 JP 2011059891
(71) Applicant: Nitto Denko Corporation, Ibaraki-shi, Osaka 567-8680 (JP)
(72) Inventor: Soejima, Kazuki, Ibaraki-shi, Osaka 567-8680 (JP); Shimokawa, Daisuke, Ibaraki-shi, Osaka 567-8680 (JP); Hirayama, Takamasa, Ibaraki-shi, Osaka 567-8680 (JP)
(74) Representative: Grünecker, Kinkeldey, Stockmair & Schwanhäusser

(57) **Abstract**

In the production process of electronic parts, since a surface resistance value is too much increased after heat foaming of a pressure-sensitive adhesive layer, static electricity is easily accumulated in electronic parts, and the static electricity has interfered with the performance of the electronic parts. This problem has been solved by a pressure-sensitive adhesive tape for temporary fixing of electronic parts of the present invention including at least a supporting substrate film and a thermally expandable pressure-sensitive adhesive layer provided on one side of the substrate, wherein the thermally expandable pressure-sensitive adhesive layer contains thermally expandable microspheres and an ionic liquid; the content of the ionic liquid is 0.01 to 10 parts by weight based on 100 parts by weight of a polymer contained in the thermally expandable pressure-sensitive adhesive layer; the surface resistance of the thermally expandable pressure-sensitive adhesive layer is 1.0 x 10¹³ Ω/□ or less; and the ratio of the surface resistance after heating for foaming to that before the heating is 5.0 or less.

## Description

### BACKGROUND OF THE INVENTION

### Field of the Invention

The present invention relates to a pressure-sensitive adhesive tape for fixing electronic parts having antistatic performance, particularly to a pressure-sensitive adhesive tape for temporary fixing having antistatic performance which is used when electrical, electronic, and semiconductor parts are produced.

### Description of the Related Art

There has been known a pressure-sensitive adhesive tape for fixing or protecting parts in a production process when electrical, electronic, and semiconductor parts are produced. Such a pressure-sensitive adhesive tape includes a tape having a base film and a peelable acrylic pressure-sensitive adhesive layer provided on the base film and a tape provided with a thermally expandable pressure-sensitive adhesive layer which has strong resistance to external force at the time of attachment but is naturally peelable from an adherend by heating at the time of peeling.
This pressure-sensitive adhesive tape is peeled when a predetermined treatment process is completed, but at that time static electricity is generated at a peeling interface between an adherend (such as a circuit) and the pressure-sensitive adhesive. In order to suppress a bad influence on the adherend by the static electricity, there are used a pressure-sensitive adhesive tape in which the back side of a base film is subjected to antistatic treatment, a tape in which an antistatic agent is added and mixed in a base film, a pressure-sensitive adhesive tape in which an antistatic agent is added and mixed in an adhesive layer, and a pressure-sensitive adhesive tape in which an antistatic intermediate layer is prepared between a base film and an adhesive layer.

However, when the parts forming a circuit have a substrate of an insulating material such as ceramic and glass, the parts have a feature of requiring time for the damping of the generated static electricity. The use of the pressure-sensitive adhesive tapes as described above for such parts does not provide a sufficient antistatic effect and has caused a large risk of circuit destruction. Therefore, in the production process of the above parts, real situation is that pressure-sensitive adhesive tapes are used, for example, in a surrounding environment which has been treated with static elimination equipment such as an ionizer. However, the countermeasures as described above do not provide a sufficient antistatic effect, leading to low productivity and insufficient protective properties.
Further, it is probably more effective to apply the treatment for preventing the peel charge of a pressure-sensitive adhesive tape to the pressure-sensitive adhesive layer side than to the base film side. However, the addition, to a pressure-sensitive adhesive, of a material having an antistatic effect such as a conventional common surfactant, a conductive filler, carbon black, and a quaternary ammonium acrylate copolymer as described in Japanese Patent Laid-Open No. 2001-323228 could not provide a sufficient antistatic effect at the time of heat peeling. In this case, when electric parts are recovered by heat peeling, a short circuit of the electronic parts may occur, resulting in extreme reduction in the yield. Therefore, the improvement in the yield has been desired.

Further, as described in Japanese Patent Laid-Open No. 2010-202692, there is known a pressure-sensitive adhesive composition in which a compound having antistatic properties other than ionic liquids such as lithium perchlorate and a conductive resin is used.
In addition, a pressure-sensitive adhesive tape which has a pressure-sensitive adhesive layer containing an ionic liquid as described in Japanese Patent Laid-Open No. 2010-043276 and Japanese Patent Laid-Open No. 2009-132936 has been studied.
A pressure-sensitive adhesive tape which foams by heating to reduce adhesion to lead to peeling as described in Japanese Patent Laid-Open No. 2006-152308 and Japanese Patent Laid-Open No. 2009-035609 is also known as that for temporary fixing and cutting electronic parts or semiconductor substrates.

In the production process of electronic parts, there has been required a heat-peelable pressure-sensitive adhesive tape for fixing electronic parts which does not cause short circuit of the electronic parts after peeling and is excellent in antistatic performance, in order to improve the yield of production. However, in a production process using a pressure-sensitive adhesive sheet which is peeled from electronic parts by the reduction in the adhesion due to heat foaming of a pressure-sensitive adhesive layer, even a pressure-sensitive adhesive layer having a sufficiently low surface resistance value before the heat foaming had a greatly increased surface resistance value by the heat foaming.
Therefore, in the production process of electronic parts, since a surface resistance value is too much increased after the heat foaming of a pressure-sensitive adhesive layer, static electricity is easily accumulated in electronic parts, and the static electricity has interfered with the performance of the electronic parts.

### SUMMARY OF THE INVENITON

The inventors of the instant application have intensively studied to solve the conventional problems as described above in order to provide a heat-peelable pressure-sensitive adhesive tape for fixing electronic parts which does not cause short circuit of the electronic parts after heat peeling and is excellent in antistatic performance. As a result, they have found that, in a pressure-sensitive adhesive tape at least comprising a supporting substrate film and a pressure-sensitive adhesive, an antistatic function at a level of causing no short circuit of electronic parts even after heat peeling can be imparted by providing a thermally expandable pressure-sensitive adhesive layer containing thermally expandable microspheres on one side of the supporting substrate film and further containing a conductive ionic liquid in the pressure-sensitive adhesive. The pressure-sensitive adhesive tape for temporary fixing of electronic parts of the present invention has been obtained based on these findings.

Specifically,
1. A pressure-sensitive adhesive tape for temporary fixing of electronic parts comprising at least a supporting substrate film and a thermally expandable pressure-sensitive adhesive layer provided on one side of the substrate, wherein the thermally expandable pressure-sensitive adhesive layer contains thermally expandable microspheres and an ionic liquid; the content of the ionic liquid is 0.01 to 10 parts by weight based on 100 parts by weight of a polymer contained in the thermally expandable pressure-sensitive adhesive layer; the surface resistance of the thermally expandable pressure-sensitive adhesive layer is 1.0 × 10¹³ Ω/□ or less; and the ratio of the surface resistance after heating for foaming to that before the heating is 5.0 or less.
2. The pressure-sensitive adhesive tape for temporary fixing of electronic parts according to claim 1, wherein the pressure-sensitive adhesive tape for temporary fixing of electronic parts has a 180° peel adhesion to an adherend PET of 0.2 to 20 N/20 mm.
3. The pressure-sensitive adhesive tape for temporary fixing of electronic parts according to claim 1 or 2, wherein the back of the substrate is subjected to antistatic treatment.

According to the present invention, even in the case where the pressure-sensitive adhesive sheet peelable by heat foaming is used for fixing electronic parts in a production process of electronic parts, the surface of the pressure-sensitive adhesive layer has a sufficiently low surface resistance value both before heat foaming and after heat foaming. Therefore, since static electricity is not accumulated in the electronic parts after peeling the heat-foamed pressure-sensitive adhesive sheet, static electricity will not interfere with the performance of the electronic parts.

### BRIEF DESCRIPTION OF THE DRAWINGS

FIG. 1 is a schematic diagram of a pressure-sensitive adhesive tape for temporary fixing of electronic parts of the present invention; and
FIG. 2 shows cutting treatment by force-cutting for the evaluation of short circuit failure.

### DETAILED DESCRIPTION OF THE PREFERRED EMBODIMENTS

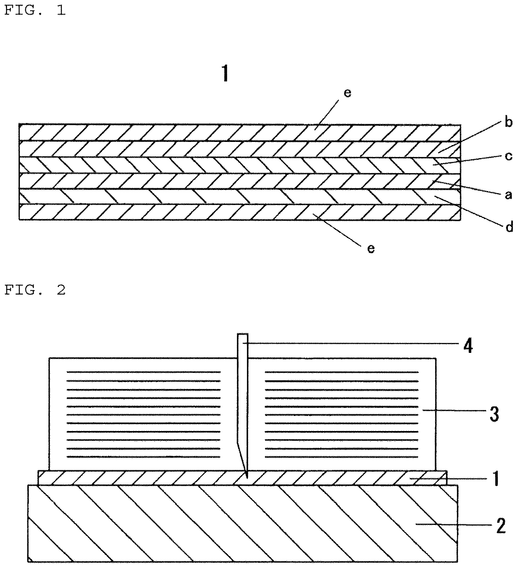

As shown in Figure 1, a pressure-sensitive adhesive tape for temporary fixing of electronic parts 1 of the present invention has a basic layer structure of a supporting substrate film (a) and a specific thermally expandable pressure-sensitive adhesive layer b formed on at least one side thereof. The tape 1 may have an elastic layer c between the supporting substrate film and the thermally expandable pressure-sensitive adhesive layer. When the thermally expandable pressure-sensitive adhesive layer is formed on one side of the supporting substrate film, another pressure-sensitive adhesive layer d to be attached to a support such as a supporting pedestal may be provided on the other side thereof.
Further, the surface of the thermally expandable pressure-sensitive adhesive layer or another pressure-sensitive adhesive layer may be covered with a separator e for the purpose of protecting the surface.

### (Supporting substrate film)

The supporting substrate film (hereinafter referred to as a "substrate") is preferably a substrate excellent in heat resistance which is not melted at a heat treatment temperature of a thermally expandable pressure-sensitive adhesive layer in terms of handleability after heating. For example, a suitable thin sheet material can be used, including a paper-based substrate such as paper; a fiber-based substrate such as cloth, a nonwoven fabric, felt, and a net; a metal-based substrate such as metal foil and a metal plate; a plastic-based substrate such as a film and a sheet of a plastic; a rubber-based substrate such as a rubber sheet; a foam such as an expanded sheet; and a laminate thereof [particularly, a laminate of a plastic-based substrate with other substrates, and a laminate of plastic films (or sheets)].
Among them, the substrate is suitably formed, for example, of a material which can be molded into a film shape, and is preferably formed of a material which can be molded into a film shape by extrusion.

Examples of materials constituting the substrate include a polyolefin resin such as a polypropylene resin, a polyethylene resin, and an ethylene-propylene copolymer; a polyester resin such as polyethylene terephthalate; an aromatic vinyl resin such as polystyrene; a polyimide resin such as nylon; a fluorine-containing resin such as polytetrafluoroethylene; and in addition to the above, an ethylene-vinyl acetate copolymer resin, polyvinyl alcohol, polyvinyl chloride, and cellulose.

Note that other than the resins as described above, various components generally known as additives for resin molding may be optionally added to the materials constituting the substrate. Examples of the additives include an oxidation inhibitor, a neutralizing agent, a heat stabilizer, a light stabilizer, an ultraviolet absorber, an antistatic agent, a slipping agent, an antiblocking agent, and a colorant (such as pigment and dye).

These additives may be used alone or in combination of two or more. Further, as described above, the substrate may have a single-layer structure or may have a laminated structure having two or more layers composed of the materials constituting the substrate.
Furthermore, aside from a peeling treatment layer to be described below, a layer for imparting strength, heat resistance, and the like may be separately provided in the substrate. It is suitable that such a separate layer has a thickness of, for example, about 10 to 500 µm, more preferably about 10 to 200 µm, depending on the purpose.
Further, although an antistatic agent and the like may be added to the substrate as described above, antistatic properties and the like can also be imparted to the substrate by forming an antistatic agent layer and the like on the substrate surface.

The substrate may have a peeling treatment layer, a known pressure-sensitive adhesive layer, or the thermally expandable pressure-sensitive adhesive layer of the present invention, on the surface on the opposite side of the surface on which the thermally expandable pressure-sensitive adhesive layer is provided.

Further, similar to a common release treatment separator for pressure-sensitive adhesive tapes, the peeling treatment layer can be formed by surface treatment in which a known release agent (for example, a silicon-based release agent or the like) is applied. Alternatively, the substrate material itself may be formed of a material having release properties, for example, a silicone-modified polyolefin resin in which a silicone is chemically bonded to an olefinic polymer to thereby form the surface layer as a peeling treatment layer.

Further, the surface of the substrate on the side for providing a thermally expandable pressure-sensitive adhesive layer may be subjected to chemical or physical treatment such as chromate treatment, ozone exposure, exposure to flame, high pressure electric shock exposure, and ionizing radiation treatment, coating treatment with a primer (such as an adhesive material), and the like, in order to increase adhesiveness with the pressure-sensitive adhesive layer.
The thickness of the substrate is not particularly limited, but it is suitably about 5 to about 500 µm, preferably about 10 to about 300 µm, more preferably about 25 to about 200 µm.

### (Thermally expandable pressure-sensitive adhesive layer)

The thermally expandable pressure-sensitive adhesive layer can be formed of a thermally expandable pressure-sensitive adhesive in which a pressure-sensitive adhesive is blended with thermally expandable microspheres and may have fine unevenness on the surface (pressure-sensitive adhesive surface) thereof. A known pressure-sensitive adhesive can be used as the pressure-sensitive adhesive and it is not particularly limited, but it is preferred to use a pressure-sensitive adhesive based on a rubber-based material or a resin which permits and does not restrain the foaming and/or expansion of the thermally expandable microspheres at the time of heating.

Further, the thermally expandable pressure-sensitive adhesive layer contains an ionic liquid as an antistatic agent, which suppresses bleeding of the antistatic agent and results in a thermally expandable pressure-sensitive adhesive layer which keeps excellent adhesion reliability to an adherend with the passage of time or in high temperature. Although the reason why bleeding is suppressed by using an ionic liquid is not obvious, sufficient antistatic ability can be obtained with a very small amount of contamination to the adherend surface because the ionic liquid shows excellent conductivity by itself.
Further, since the above ionic liquid is liquid at room temperature, it can be easily added and dispersed or dissolved in the pressure-sensitive adhesive compared with a solid salt. Furthermore, since the ionic liquid does not have vapor pressure (nonvolatile), antistatic characteristics are continuously obtained without disappearing with time.

The content of the ionic liquid which is an electrostatic discharge agent contained in the thermally expandable pressure-sensitive adhesive layer is 0.01 to 10 parts by weight, preferably 0.05 to 8 parts by weight, more preferably 0.1 to 5 parts by weight, based on 100 parts by weight of a polymer. When the content is the range of 0.01 to 10 parts by weight, a sufficient antistatic effect can be obtained; contamination of an adherend by the ionic liquid can be prevented; and the increase in the fraction defective due to the reduction in force-cutting accuracy can be prevented.

In the present invention, the surface resistance of the thermally expandable pressure-sensitive adhesive layer is 1.0 × 10¹³ Ω/□ or less, preferably 1.0 × 10¹² Ω/□ or less, more preferably 1.0 × 10¹¹ Ω/□ or less; and the ratio of the surface resistance after heating for foaming to that before the heating is 5.0 or less, preferably 4.0 or less, more preferably 3.0 or less.
When the surface resistance of the thermally expandable pressure-sensitive adhesive layer is 1.0 × 10¹³ Ω/□ or less and the ratio of the surface resistance after heating for foaming to that before the heating is 5.0 or less, short circuit failure will not occur after heating and the yield of a product will be good.
Further, the thermally expandable pressure-sensitive adhesive layer is preferably such a pressure-sensitive adhesive layer that the pressure-sensitive adhesive tape for temporary fixing of electronic parts has a 180° peel adhesion to an adherend PET of 0.2 to 20 N/20 mm, more preferably 1.0 to 10 N/20 mm, still more preferably 3.0 to 10 N/20 mm.
When the peel adhesion is within the range of 0.2 to 20 N/20 mm, peeling of the pressure-sensitive adhesive tape for temporary fixing of the present invention from electronic parts after heating will require only a small peeling strength and in particular will not damage the electronic parts at the time of peeling.

Examples of the pressure-sensitive adhesive include pressure-sensitive adhesives using, as a base polymer, natural rubber, various synthetic rubbers, and polymers based on acrylate, vinyl alkyl ether, silicone, polyester, polyamide, urethane, a styrene-diene block copolymer, and the like. It is also possible to use, as a base polymer, polymers in which creep characteristics are improved by blending a heat-meltable resin having a melting point of about 200°C or less with the polymers.
The thermally expandable pressure-sensitive adhesive layer may be formed, for example, by using any of a solvent-type pressure-sensitive adhesive, an emulsion-type pressure-sensitive adhesive, and a water soluble adhesive.
It is also possible to use a pressure-sensitive adhesive having various characteristics such as a heat-peelable pressure-sensitive adhesive and an energy ray-curable pressure-sensitive adhesive. Note that the heat-peelable pressure-sensitive adhesive is a pressure-sensitive adhesive which has pressure-sensitive adhesive properties in the beginning and the adhesion can be reduced by heating. In this case, the heat-peelable pressure-sensitive adhesive is heated, for example, to about 70 to about 200°C, wherein the temperature is properly selected according to materials such as a substrate film.

An acrylic copolymer can be particularly suitably used as a base polymer. It is preferred to use an alkyl (meth)acrylate having an alkyl group having 20 carbon atoms or less as the main monomer component of the acrylic copolymer. Examples of the alkyl group having 20 carbon atoms or less include a methyl group, an ethyl group, a propyl group, a butyl group, an amyl group, a hexyl group, a heptyl group, a 2-ethylhexyl group, an isooctyl group, an isodecyl group, a dodecyl group, a lauryl group, a tridecyl group, a pentadecyl group, a hexadecyl group, a heptadecyl group, an octadecyl group, a nonadecyl group, and an eicosyl group. One or two or more alkyl (meth)acrylates can be selected for use as the main monomer component. Note that these alkyl (meth) acrylates are generally contained in the base polymer of the pressure-sensitive adhesive in an amount of 50% by weight or more.

The acrylic copolymer may optionally contain a copolymerizable monomer suitable for improving cohesive strength, heat resistance, and the like, in addition to the above alkyl (meth)acrylates. Examples of the above copolymerizable monomer include carboxyl group-containing monomers such as acrylic acid, methacrylic acid, carboxyethyl acrylate, carboxypentyl acrylate, itaconic acid, maleic acid, fumaric acid, and crotonic acid; acid anhydrides such as maleic anhydride and itaconic acid anhydride; hydroxyl group-containing monomers such as hydroxyethyl (meth)acrylates, hydroxypropyl (meth)acrylates, hydroxybutyl (meth)acrylates, hydroxyhexyl (meth)acrylates, hydroxyoctyl (meth)acrylates, hydroxydecyl (meth)acrylates, hydroxylauryl (meth)acrylates, and (4-hydroxymethylcyclohexyl)methyl(meth)acrylates; sulfonic acid group-containing monomers such as styrene sulfonic acid, allyl sulfonic acid, 2-(meth)acrylamide-2-methylpropane sulfonic acid, (meth)acrylamide propane sulfonic acid, sulfopropyl (meth)acrylate, and (meth)acryloyloxy naphthalene sulfonic acid; (N-substituted)amide monomers such as (meth)acrylamide, N,N-dimethyl(meth)acrylamide, N-butyl(meth)acrylamide, N-methylol(meth)acrylamide, and N-methylolpropane(meth)acrylamide; alkylamino (meth)acrylate monomers such as aminoethyl (meth)acrylate, aminoethyl (meth)acrylate, N,N-dimethylaminoethyl (meth)acrylate, and t-butylaminoethyl (meth)acrylate; alkoxyalkyl (meth)acrylate monomers such as methoxyethyl (meth)acrylate and ethoxyethyl (meth)acrylate; maleimide monomers such as N-cyclohexylmaleimide, N-isopropylmaleimide, N-laurylmaleimide, and N-phenylmaleimide; itaconimide monomers such as N-methylitaconimide, N-ethylitaconimide, N-butylitaconimide, N-octylitaconimide, N-2-ethylhexylitaconimide, N-cyclohexylitaconimide, and N-laurylitaconimide; succinimide monomers such as N-(meth)acryloyloxymethylenesuccinimide, N-(meth)acryloyl-6-oxyhexamethylenesuccinimide, and N-(meth)acryloyl-8-oxyoctamethylenesuccinimide; vinyl monomers such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxamide, styrene, α-methylstyrene, and N-vinylcaprolactam; cyanoacrylate monomers such as acrylonitrile and methacrylonitrile; epoxy group-containing acrylic monomers such as glycidyl (meth)acrylate; glycol acrylate monomers such as polyethylene glycol (meth)acrylate, polypropylene glycol (meth)acrylate, methoxyethylene glycol (meth)acrylate, and methoxypolypropylene glycol (meth)acrylate; acrylate monomers such as tetrahydrofurfuryl (meth)acrylate, fluorinated (meth)acrylates, silicone (meth)acrylate, and 2-methoxyethyl acrylate; polyfunctional monomers such as hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylates, polyester acrylates, and urethane acrylates; and isoprene, butadiene, isobutylene, and vinyl ethers. These copolymerizable monomers can be used alone or in combination of two or more.

The base polymer constituting the thermally expandable pressure-sensitive adhesive layer can be prepared by subjecting the monomers as described above to polymerization. The polymerization method is not particularly limited and can be arbitrarily selected from known polymerization methods commonly used, such as a solution polymerization method, a bulk polymerization method, an emulsion polymerization method, to which a polymerization initiator is added.

When an energy ray-curable pressure-sensitive adhesive is formed as the pressure-sensitive adhesive, it is suitable to use or add a polymer obtained by reacting a reactive functional group-containing acrylic polymer, which is chemically modified with a functional group having a carbon-carbon multiple bond such as an acryloyl group, a methacryloyl group, a vinyl group, an allyl group, and an acetylenic group and is specifically obtained by copolymerization of a monomer containing a reactive functional group such as a hydroxyl group and/or a carboxyl group [for example, 2-hydroxyethyl (meth)acrylate, (meth)acrylic acid, and the like] with an alkyl (meth)acrylate, with a compound having in the molecule a group reacting with the above reactive functional group (such as an isocyanate group and an epoxy group) and an energy ray-reactive functional group (such as an acryloyl group and a methacryloyl group) [for example, (meth)acryloyl oxyethylene isocyanate].

Alternatively, an energy ray-curable compound may be used or added. Such a compound is not particularly limited as far as it is curable particularly with the energy ray, especially an ultraviolet ray or the like, but is preferably a compound which efficiently forms a three-dimensional network after energy ray irradiation.
Examples of the above compound include trimethylolpropane triacrylate, tetramethylolmethane tetraacrylate, pentaerythritol monohydroxypentaacrylate, 1,4-butanediol diacrylate, 1,6-hexanediol diacrylate, and polyethylene glycol diacrylate.

An ultraviolet-curable resin may be used as the ultraviolet-curable compound, and examples of the resin that may be used include an ester (meth)acrylate, a urethane (meth)acrylate, an epoxy (meth)acrylate, a melamine (meth)acrylate, an acrylic resin (meth)acrylate, each having a (meth)acryloyl group at a molecular end, a thiol-ene addition type resin having an allyl group at a molecular end; a photo-cationic polymerizable resin; a cinnamoyl group-containing polymer such as polyvinyl cinnamate; a diazotized amino novolac resin, an acrylamide type polymer; and a photosensitive reaction group-containing polymer or oligomer.

A mixture of an organic salt such as an onium salt and a compound having a plurality of heterocyclic rings in the molecule can also be used as the energy ray-curable compound.
Such a mixture produce ions by the cleavage of the organic salt caused by the irradiation of energy rays, and the ions can serve as initiation species to cause ring opening reaction of the heterocyclic rings to form a three-dimensional network structure. The organic salt includes an iodonium salt, a phosphonium salt, an antimonium salt, a sulfonium salt, and a borate salt.
The heterocyclic ring in the compound having a plurality of heterocyclic rings in the molecule includes oxirane, oxetane, oxolane, thiirane, and aziridine.

Epoxidized polybutadiene, unsaturated polyester, polyglycidylmethacrylate, polyacrylamide, polyvinyl siloxane, and the like may also be used as the polymer which reacts by the irradiation of ultraviolet rays.
When an ultraviolet-curable compound or the like is added, the blending amount can be arbitrarily controlled according to the type and the like of a base polymer, an ultraviolet-curable compound, and the like to be used. For example, it is suitable to control the blending amount to such a level that the pressure-sensitive adhesive sheet has an adhesion that is larger than 0.3 N/20 mm before the sheet is irradiated with the energy rays and 0.3 N/20 mm or less after it is irradiated with energy rays.
For example, the blending amount is suitably about 5 to about 500 parts by weight, preferably about 15 to 300 parts by weight, more preferably about 20 to 150 parts by weight, based on 100 parts by weight of the base polymer constituting the thermally expandable pressure-sensitive adhesive layer.

More specifically, the blending amount is preferably controlled so that the adhesion to a silicon mirror wafer before ultraviolet ray irradiation is larger than 0.3 N/20 mm and the adhesion to the silicon mirror wafer after ultraviolet ray irradiation is 0.3 N/20 mm or less, in the 90° peel adhesion test (peel rate: 300 mm/min) according to JIS Z 0237.

It is preferred that the thermally expandable pressure-sensitive adhesive layer using an energy ray-curable pressure-sensitive adhesive is optionally blended with an ultraviolet polymerization initiator for curing an ultraviolet-curable compound and an additive such as an ultraviolet polymerization initiator for obtaining a suitable elastic modulus before and after ultraviolet curing.

Typical energy ray polymerization initiators include ketone-based initiators such as benzophenone, acetophenone, quinone, naphthoquinone, anthraquinone, and fluorenone; azo initiators such as azobisisobutyronitrile; and peroxide initiators such as benzoyl peroxide and perbenzoic acid.
Examples of commercially available energy ray polymerization initiators include "IRGACURE 184" and "IRGACURE 651", which are trade names of the initiators manufactured by Ciba-Geigy Ltd.
A known polymerization initiator can be arbitrarily selected as the ultraviolet polymerization initiator.
The blending amount is suitably about 0.1 to about 10 parts by weight, preferably about 1 to about 5 parts by weight based on 100 parts by weight of a sticky substance. Optionally, an ultraviolet polymerization promoter may be used with the ultraviolet polymerization initiator.

When forming a thermally expandable pressure-sensitive adhesive layer, one or two or more of common additives such as a tackifier, a viscosity controlling agent, a leveling agent, a plasticizer, a filler, a colorant such as pigment/dye, a stabilizer, a preservative, an antiaging agent, and an antistatic agent may be added to the thermally expandable pressure-sensitive adhesive layer.

Various additives may be optionally added to the pressure-sensitive adhesive constituting the thermally expandable pressure-sensitive adhesive layer. Examples of such additives include various known additives, such as known or conventional tackifiers (for example, a rosin-based resin, a terpene-based resin, a petroleum resin, a coumarone-indene resin, a styrenic resin, and the like), crosslinking agents (for example, an epoxy crosslinking agent, an isocyanate crosslinking agent, a polyfunctional acrylate crosslinking agent, and the like), a filler, a colorant (such as pigment and dye), an oxidation inhibitor, an ultraviolet absorber, and a surfactant. The amount of each of these additives used may be a conventional amount applied to the pressure-sensitive adhesive.

Thermally expandable microspheres in which a suitable substance which is easily gasified to show expansibility such as isobutane, propane, and pentane is encapsulated in a shell-forming substance by a coacervation method, interfacial polymerization, or the like can be used as the above thermally expandable microspheres. A substance showing heat meltability and a substance destroyed by thermal expansion can be used as the shell-forming substance. Examples of the shell-forming substance include a vinylidene chloride-acrylonitrile copolymer, polyvinyl alcohol, polyvinyl butyral, polymethylmethacrylate, polyacrylonitrile, polyvinylidene chloride, and polysulfone. Thermally expandable microspheres to be used preferably has a volume expansion magnification of, for example, 5 times or more, preferably 7 times or more, most preferably 10 times or more, in order to develop good heat peelability.

The blending amount of the thermally expandable microspheres can be arbitrarily selected without particular limitation, depending on the degree to which the thermally expandable pressure-sensitive adhesive layer is expanded (foamed) or the degree to which adhesive strength is reduced. For example, the blending amount can be selected from the range of 1 to 150 parts by weight, preferably 25 to 100 parts by weight, based on 100 parts by weight of the base polymer constituting the thermally expandable pressure-sensitive adhesive layer as described above.

The thickness of the thermally expandable pressure-sensitive adhesive layer is not particularly limited, and is, for example, suitably about 5 to 300 µm, particularly about 5 to 150 µm, more preferably about 10 to 100 µm.
When the thickness of the thermally expandable pressure-sensitive adhesive layer is in the range of 5 to 300 µm, the contact area with an adherend will be not too small and adhesive strength to an adherend before heat treatment can be prevented from being reduced even when unevenness is caused on the surface by the thermally expandable microspheres. Further, since the thermally expandable pressure-sensitive adhesive layer is not too thick, the thermally expandable pressure-sensitive adhesive layer is hardly deformed, which allows highly accurate processing, including preventing deviation from occurring when an adherend is processed. Furthermore, good heat peelability can be obtained, including preventing a paste residue to an adherend from being produced, which is caused by cohesive failure occurring at the time of expansion by heat treatment.

When the thermally expandable pressure-sensitive adhesive layer has unevenness on the surface thereof (pressure-sensitive adhesive surface), each uneven part may have the same shape; or some of the uneven parts may have the same shape; or all of the uneven parts may have different shapes. Note that when some of the uneven parts have the same shape, or all of the uneven parts have different shapes (that is, when not all the uneven parts have the same shape), the uneven parts may be regularly different in shape or may be irregularly different in shape. Further, the uneven parts may be arranged in regular positional relationship (or space) or may be arranged in irregular positional relationship (or space). Accordingly, all the uneven parts may be the same in shape, or the uneven parts may be regularly or irregularly different in shape, and these uneven parts may be arranged in regular or irregular positional relationship (or space). With respect to the uneven parts of the thermally expandable pressure-sensitive adhesive layer, it is preferred that the uneven parts are irregularly different in shape, and are arranged in irregular positional relationship.

When the uneven parts exist on the surface of the thermally expandable pressure-sensitive adhesive layer, the maximum cross section height Rt can be selected from the range of 0.5 to 12 µm, preferably 1 to 12 µm, most preferably 3 to 8 µm. When the maximum cross section height is larger than 12 µm, it often exceeds the maximum cross section height Rt' of the surface of an adherend, resulting in insufficient adhesion to an adherend having a roughened surface, which is not suitable for use in the method for processing an adherend of the present invention. Note that when the maximum cross section height of the surface of an adhesive layer exceeds 12 µm, satisfactory adhesive strength is not obtained also for a smooth adherent surface in many cases. Further, when the maximum cross section height Rt is smaller than 0.5 µm and the adherent surface is a roughened surface, followability to the roughened surface will be insufficient and satisfactory adhesive strength required for processing the adherend cannot be developed, and thus correct processing may be unable to be performed to the adherend.

The surface roughness (average roughness) Ra of the surface of the thermally expandable pressure-sensitive adhesive layer is not particularly limited, but can be selected, for example, from the range of 0.5 to 5 µm, preferably 1 to 3 µm.
The above maximum cross section height Rt and surface roughness Ra can be measured, for example, by using a contact-type surface roughness measuring instrument "P-11" manufactured by TENCOR Ltd.

The uneven parts of the surface of the thermally expandable pressure-sensitive adhesive layer can be formed by using a known uneven part forming method. Examples of the method include a method of preparing a coating liquid in which a pressure-sensitive adhesive, thermally expandable microspheres, and optionally other components are dissolved or dispersed in a suitable solvent and applying the coating liquid to a substrate to form a pressure-sensitive adhesive layer, followed by bonding a separator having unevenness thereto; and a method of applying the above coating liquid to a separator having unevenness to form a thermally expandable pressure-sensitive adhesive layer, followed by transferring it to a substrate or an elastic layer. Note that the separator having uneven parts can be produced by suitable known methods, such as a method of processing the separator surface by sandblasting or the like; and a method of hot pressing against a separator a roller which is subjected to uneven processing.

### (Ionic liquid)

Ionic liquid is a liquid organic compound and refers to a molten salt (ionic compound) which represents a liquid state at room temperature, and it has good compatibility with a base polymer in a pressure-sensitive adhesive composition. This can suppress segregation of the ionic liquid on the surface of a pressure-sensitive adhesive layer and prevent reduction in adhesion with time and contamination due to the transfer thereof to an adherend. Further, compatibility means a property in which when a base polymer is mixed with the ionic liquid with a suitable mixing method (melt blending, solution blending), they are uniformly mixed and hardly phase-separated.
The content of the ionic liquid is 0.01 to 10 parts by weight, preferably 0.05 to 8 parts by weight, more preferably 0.1 to 5 parts by weight based on 100 parts by weight of the polymer contained in the thermally expandable pressure-sensitive adhesive layer. When the content is in the range of 0.01 to 10 parts by weight, sufficient antistatic effect can be obtained, and the increase in the fraction defective due to the reduction in force-cutting accuracy can be prevented.

Although the details of the reason why excellent antistatic properties can be obtained by using the ionic liquid are not obvious, it is guessed as follows. That is, since the ionic liquid is liquid, molecular motion thereof is easy compared with a commonly used surfactant, and the rearrangement of molecules easily occurs according to generation of charges. Accordingly, it is thought that the excellent antistatic effect is obtained because the charge neutralization mechanism by molecular rearrangement may work when the ionic liquid is used. Further, since the ionic liquid represents a liquid state at room temperature, it can be easily added and dispersed or dissolved in the pressure-sensitive adhesive compared with a solid salt. Furthermore, since the ionic liquid does not have vapor pressure (nonvolatile), it has a feature that antistatic properties are continuously obtained without disappearing with time.

As the ionic liquid of the present invention, a nitrogen-containing onium salt, a sulfur-containing onium salt, and a phosphorus-containing onium salt are particularly preferred, and a salt consisting of an organic cation component represented by the following general formulas (A) to (D) and an anion component are preferably used because a particularly excellent antistatic ability is obtained.

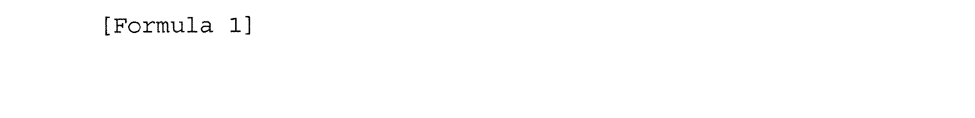

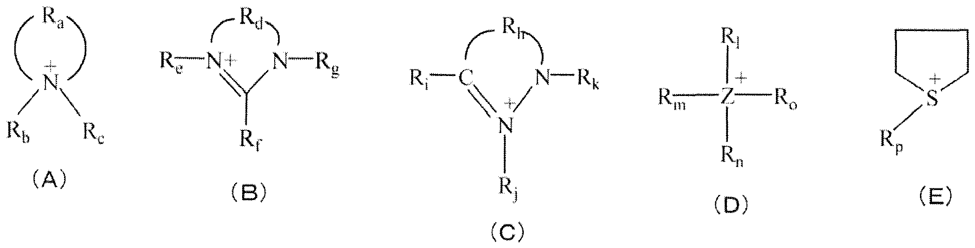

In formula (A), Rₐ represents a hydrocarbon group having 4 to 20 carbon atoms, which may contain a hetero atom; and R_{b} and R_{c} may be the same or different and each represent hydrogen or a hydrocarbon group having 4 to 16 carbon atoms, which may contain a hetero atom, with the proviso that R_{c} is not present when the nitrogen atom involves a double bond.
In formula (B), R_{d} represents a hydrocarbon group having 4 to 20 carbon atoms, which may contain a hetero atom; and Rₑ, R_{f}, and Rg may be the same or different and each represent hydrogen or a hydrocarbon group having 1 to 16 carbon atoms, which may contain a hetero atom.
In formula (C), Rₕ represents a hydrocarbon group having 4 to 20 carbon atoms, which may contain a hetero atom; and Rᵢ, Rⱼ, and Rₖ may be the same or different and each represent hydrogen or a hydrocarbon group having 1 to 16 carbon atoms, which may contain a hetero atom.
In formula (D), Z represents a nitrogen, sulfur, or phosphorus atom; and Rₗ, Rₘ, Rₙ, and Rₒ may be the same or different and each represent a hydrocarbon group having 1 to 20 carbon atoms, which may contain a hetero atom, with the proviso that Rₒ is not present when Z is a sulfur atom.
In formula (E), Rₚ represents a hydrocarbon group having 1 to 18 carbon atoms, which may contain a hetero atom.

The cations represented by formula (A) include a pyridinium cation, a piperidinium cation, a pyrrolidinium cation, a cation having a pyrroline skeleton, and a cation having a pyrrole skeleton.
Specific examples thereof include pyridinium cations such as a 1-ethylpyridinium cation, a 1-butylpyridinium cation, a 1-hexylpyridinium cation, a 1-butyl-3-methylpyridinium cation, a 1-butyl-4-methylpyridinium cation, a 1-hexyl-3-methylpyridinium cation, and a 1-butyl-3,4-dimethylpyridinium cation; piperidinium cations such as a 1-propylpiperidinium cation, a 1-pentylpiperidinium cation, a 1,1-dimethylpiperidinium cation, a 1-methyl-1-ethylpiperidinium cation, a 1-methyl-1-propylpiperidinium cation, a 1-methyl-1-butylpiperidinium cation, a 1-methyl-1-pentylpiperidinium cation, a 1-methyl-1-hexylpiperidinium cation, a 1-methyl-1-heptylpiperidinium cation, a 1-ethyl-1-propylpiperidinium cation, a 1-ethyl-1-butylpiperidinium cation, a 1-ethyl-1-pentylpiperidinium cation, a 1-ethyl-1-hexylpiperidinium cation, a 1-ethyl-1-heptylpiperidinium cation, a 1,1-dipropylpiperidinium cation, a 1-propyl-1-butylpiperidinium cation, and a 1,1-dibutylpiperidinium cation; pyrrolidinium cations such as a 1,1-dimethylpyrrolidinium cation, a 1-methyl-1-ethylpyrrolidinium cation, a 1-methyl-1-propylpyrrolidinium cation, a 1-methyl-1-butylpyrrolidinium cation, a 1-methyl-1-pentylpyrrolidinium cation, a 1-methyl-1-hexylpyrrolidinium cation, a 1-methyl-1-heptylpyrrolidinium cation, a 1-ethyl-1-propylpyrrolidinium cation, a 1-ethyl-1-butylpyrrolidinium cation, a 1-ethyl-1-pentylpyrrolidinium cation, a 1-ethyl-1-hexylpyrrolidinium cation, a 1-ethyl-1-heptylpyrrolidinium cation, a 1,1-dipropylpyrrolidinium cation, a 1-propyl-1-butylpyrrolidinium cation, and a 1,1-dibutylpyrrolidinium cation; a 2-methyl-1-pyrroline cation, a 1-ethyl-2-phenylindole cation, a 1,2-dimethylindole cation, and a 1-ethylcarbazole cation.

The cations represented by formula (B) include an imidazolium cation, a tetrahydropyrimidinium cation, and a dihydropyrimidinium cation.
Specific examples thereof include imidazolium cations such as a 1,3-dimethylimidazolium cation, a 1,3-diethylimidazolium cation, a 1-ethyl-3-methylimidazolium cation, a 1-butyl-3-methylmidazolium cation, a 1-hexyl-3-methylimidazolium cation, a 1-ocytl-3-methylimidazolium cation, a 1-decyl-3-methylimidazolium cation, a 1-dodecyl-3-methylimidazolium cation, a 1-tetradecyl-3-methylimidazolium cation, a 1,2-dimethyl-3-propylimidazolium cation, a 1-ethyl-2,3-dimethylimidazolium cation, a 1-butyl-2,3-dimethylimidazolium cation, and a 1-hexyl-2,3-dimethylimidazolium cation; tetrahydropyrimidinium cations such as a 1,3-dimethyl-1,4,5,6-tetrahydropyrimidinium cation, a 1,2,3-trimethyl-1,4,5,6-tetrahydropyrimidinium cation, a 1,2,3,4-tetramethyl-1,4,5,6-tetrahydropyrimidinium cation, and a 1,2,3,5-tetramethyl-1,4,5,6-tetrahydropyrimidinium cation; dihydropyrimidinium cations such as a 1,3-dimethyl-1,4-dihydropyrimidinium cation, a 1,3-dimethyl-1,6-dihydropyrimidinium cation, a 1,2,3-trimethyl-1,4-dihydropyrimidinium cation, a 1,2,3-trimethyl-1,6-dihydropyrimidinium cation, a 1,2,3,4-tetramethyl-1,4-dihydropyrimidinium cation, and a 1,2,3,4-tetramethyl-1,6-dihydropyrimidinium cation; and 1-butyl-3-methylpyridinium cations such as a 1-butyl-3-methylpyridinium bisimide.

The cations represented by formula (C) include a pyrazolium cation and a pyrazolinium cation.
Specific examples thereof include a 1-methylpyrazolium cation, a 3-methylpyrazolium cation, and a 1-ethyl-2-methylpyrazolinium cation.

The cations represented by formula (D) include a tetraalkylammonium cation, a trialkylsulfonium cation, a tetraalkylphosphonium cation, and those cations in which a part of the alkyl group is substituted with an alkenyl group, an alkoxyl group, or an epoxy group. Further, examples of Rₗ, Rₘ, Rₙ, and Rₒ may include an alkyl group having 1 to 20 carbon atoms. Furthermore, Rₗ, Rₘ, Rₙ, and Rₒ may include an aromatic ring group and an aliphatic ring group.
Specific examples thereof include tetraalkylammonium cations such as an N,N-dimethyl-N-ethyl-N-propylammonium cation, an N,N-dimethyl-N-ethyl-N-butylammonium cation, an N,N-dimethyl-N-ethyl-N-pentylammonium cation, an N,N-dimethyl-N-ethyl-N-hexylammonium cation, an N,N-dimethyl-N-ethyl-N-heptylammonium cation, an N,N-dimethyl-N-ethyl-N-nonylammonium cation, an N,N-dimethyl-N,N-dipropylammonium cation, an N,N-dimethyl-N-propyl-N-butylammonium cation, an N,N-dimethyl-N-propyl-N-pentylammonium cation, an N,N-dimethyl-N-propyl-N-hexylammonium cation, an N,N-dimethyl-N-propyl-N-heptylammonium cation, an N,N-dimethyl-N-butyl-N-hexylammonium cation, an N,N-dimethyl-N-butyl-N-heptylammonium cation, an N,N-dimethyl-N-pentyl-N-hexylammonium cation, an N,N-dimethyl-N,N-dihexylammonium cation, a trimethylheptylammonium cation, an N,N-diethyl-N-methyl-N-propylammonium cation, an N,N-diethyl-N-methyl-N-pentylammonium cation, an N,N-diethyl-N-methyl-N-heptylammonium cation, an N,N-diethyl-N-propyl-N-pentylammonium cation, a triethylmethylammonium cation, a triethylpropylammonium cation, a triethylpentylammonium cation, a triethylheptylammonium cation, an N,N-dipropyl-N-methyl-N-ethylammonium cation, an N,N-dipropyl-N-methyl-N-pentylammonium cation, an N,N-dipropyl-N-butyl-N-hexylammonium cation, an N,N-dipropyl-N,N-dihexylammonium cation, an N,N-dibutyl-N-methyl-N-pentylammonium cation, an N,N-dibutyl-N-methyl-N-hexylammonium cation, a trioctylmethylammonium cation, an N-methyl-N-ethyl-N-propyl-N-pentylammonium cation, a tetramethylammonium cation, a tetraethylammonium cation, a tetrabuthylammonium cation, a tetrahexylammonium cation, a tributylethylammonium cation, a trimethyldecylammonium cation, an N,N-diethyl-N-methyl-N-(2-methoxyethyl)ammonium cation, a glycidyltrimethylammonium cation, and a diallyldimethylannmonium cation; and trialkylsulfonium cations such as a trimethylsulfonium cation, a triethylsulfonium cation, a tributylsulfonium cation, a trihexylsulfonium cation, a diethylmethylsulfonium cation, a dibutylethylsulfonium cation, and a dimethyldecylsulfonium cation; tetraalkylphosphonium cations such as a tetramethylphosphonium cation, a tetraethylphosphonium cation, a tetrabuthylphosphonium cation, a tetrahexylphosphonium cation, a phosphonium cation, a triethylmethylphosphonium cation, a tributylethylphosphonium cation, and a trimethyldecylphosphonium cation.

In the present invention, among the above cation components, the cations represented by formula (A) (particularly, pyridinium cations such as a 1-ethylpyridinium cation, a 1-butylpyridinium cation, a 1-hexylpyridinium cation, a 1-butyl-3-methylpyridinium cation, a 1-butyl-4-methylpyridinium cation, a 1-hexyl-3-methylpyridinium cation, and a 1-butyl-3,4-dimethylpyridinium cation), and the cations represented by formula (D) (particularly, unsymmetrical tetraalkylammonium cations, trialkylsulfonium cations, and tetraalkylphosphonium cations such as a triethylmethylammonium cation, a tributylethylammonium cation, a trimethyldecylammonium cation, a diethylmethylsulfonium cation, a dibutylethylsulfonium cation, a dimethyldecylsulfonium cation, a triethylmethylphosphonium cation, a tributylethylphosphonium cation, and a trimethyldecylphosphonium cation, and an N,N-diethyl-N-methyl-N-(2-methoxyethyl)ammonium cation, a diallyldimethylannmonium cation, a glycidyltrimethylammonium cation, and the like) are preferably used in that they provide particularly excellent antistatic ability.

Specific examples of the cations represented by formula (E) include sulfonium salts each having an alkyl group having 1 to 18 carbon atoms such as a methyl group, an ethyl group, a propyl group, a butyl group, a hexyl group, an octyl group, a nonyl group, a decyl group, a dodecyl group, a tridecyl group, a tetradecyl group, and an octadecyl group, as Rp.

On the other hand, the anion component is not particularly limited as far as it can form an ionic liquid with the above cation component, and examples thereof include Cl⁻, Br⁻, I⁻, AlCl₄⁻, Al₂Cl₇⁻, BF₄⁻, PF₆⁻, ClO₄⁻, NO₃⁻, CH₃COO⁻, CF₃COO⁻, CH₃SO₃⁻, CF₃SO₃⁻, (CF₃SO₂)₂N⁻, (CF₃SO₂)₃C⁻, AsF₆⁻, SbF₆⁻, NbF₆⁻, TaF₆⁻, F(HF)ₙ⁻, (CN)₂N⁻, C₄F₉SO₃⁻, (C₂F₅SO₂)₂N⁻, C₃F₇COO⁻, and (CF₃SO₂) (CF₃CO)N⁻. Among them, the anion component containing a fluorine atom is preferably used because it provides an ionic compound having a low melting point.
There is a tendency for a hydrophobic anion component to hardly bleed to the surface of the pressure-sensitive adhesive surface, and it is preferably used in terms of low staining properties. Further, the anion component containing a fluorine atom is particularly used because it provides an ionic compound having a low melting point.

The ionic liquid in the present invention is suitably selected from the combinations of the above cation components and anion components and used, and examples thereof include 1-butylpyridinium tetrafluoroborate, 1-butylpyridinium hexafluorophosphate, 1-butyl-3-methylpyridinium tetrafluoroborate, 1-butyl-3-methylpyridinium trifluoromethanesulfonate, 1-butyl-3-methylpyridinium bis(trifluoromethanesulfonyl)imide, 1-butyl-3-methylpyridinium bis(pentafluoroethanesulfonyl)imide, 1-hexylpyridinium tetrafluoroborate, 1,1-dimethylpyrrolidinium bis(trifluoromethanesulfonyl)imide, 1-methyl-1-ethylpyrrolidinium bis(trifluoromethanesulfonyl)imide, 1-methyl-1-propylpyrrolidinium bis(trifluoromethanesulfonyl)imide, 1-methyl-1-butylpyrrolidinium bis(trifluoromethanesulfonyl)imide, 1-methyl-1-pentylpyrrolidinium bis(trifluoromethanesulfonyl)imide, 1-methyl-1-hexylpyrrolidinium bis(trifluoromethanesulfonyl)imide, 1-methyl-1-heptylpyrrolidinium bis(trifluoromethanesulfonyl)imide, 1-ethyl-1-propylpyrrolidinium bis(trifluoromethanesulfonyl)imide, 1-ethyl-1-butylpyrrolidinium bis(trifluoromethanesulfonyl)imide, 1-ethyl-1-pentylpyrrolidinium bis(trifluoromethanesulfonyl)imide, 1-ethyl-1-hexylpyrrolidinium bis(trifluoromethanesulfonyl)imide, 1-ethyl-1-heptylpyrrolidinium bis(trifluoromethanesulfonyl)imide, 1,1-dipropylpyrrolidinium bis(trifluoromethanesulfanyl)imide, 1-propyl-1-butylpyrrolidinium bis(trifluoromethanesulfonyl)imide, 1,1-dibutylpyrrolidinium bis(trifluoromethanesulfonyl)imide, 1-propylpiperidinium bis(trifluoromethanesulfonyl)imide, 1-pentylpiperidinium bis(trifluoromethanesulfonyl)imide, 1,1-dimethylpiperidinium bis(trifluoromethanesulfonyl)imide, 1-methyl-1-ethylpiperidinium bis(trifluoromethanesulfonyl)imide, 1-methyl-1-propylpiperidinium bis(trifluoromethanesulfonyl)imide, 1-methyl-1-butylpiperidinium bis(trifluoromethanesulfonyl)imide, 1-methyl-1-pentylpiperidinium bis(trifluoromethanesulfonyl)imide, 1-methyl-1-hexylpiperidinium bis(trifluoromethanesulfonyl)imide, 1-methyl-1-heptylpiperidinium bis(trifluoromethanesulfonyl)imide, 1-ethyl-1-propylpiperidinium bis(trifluoromethanesulfonyl)imide, 1-ethyl-1-butylpiperidinium bis(trifluoromethanesulfonyl)imide, 1-ethyl-1-pentylpiperidinium bis(trifluoromethanesulfonyl)imide, 1-ethyl-1-hexylpiperidinium bis(trifluoromethanesulfonyl)imide, 1-ethyl-1-heptylpiperidinium bis(trifluoromethanesulfonyl)imide, 1,1-dipropylpiperidinium bis(trifluoromethanesulfonyl)imide, 1-propyl-1-butylpiperidinium bis(trifluoromethanesulfonyl)imide, 1,1-dibutylpiperidinium bis(trifluoromethanesulfonyl)imide, 1,1-dimethylpyrrolidinium bis(pentafluoroethanesulfonyl)imide, 1-methyl-1-ethylpyrrolidinium bis(pentafluoroethanesulfonyl)imide, 1-methyl-1-propylpyrrolidinium bis(pentafluoroethanesulfonyl)imide, 1-methyl-1-butylpyrrolidinium bis(pentafluoroethanesulfonyl)imide, 1-methyl-1-pentylpyrrolidinium bis(pentafluoroethanesulfonyl)imide, 1-methyl-1-hexylpyrrolidinium bis(pentafluoroethanesulfonyl)imide, 1-methyl-1-heptylpyrrolidinium bis(pentafluoroethanesulfonyl)imide, 1-ethyl-1-propylpyrrolidinium bis(pentafluoroethanesulfonyl)imide, 1-ethyl-1-butylpyrrolidinium bis(pentafluoroethanesulfonyl)imide, 1-ethyl-1-pentylpyrrolidinium bis(pentafluoroethanesulfonyl)imide, 1-ethyl-1-hexylpyrrolidinium bis(pentafluoroethanesulfonyl)imide, 1-ethyl-1-heptylpyrrolidinium bis(pentafluoro ethanesulfonyl)imide, 1,1-dipropylpyrrolidinium bis(pentafluoroethanesulfonyl)imide, 1-propyl-1-butylpyrrolidinium bis(pentafluoroethanesulfonyl)imide, 1,1-dibutylpyrrolidinium bis(pentafluoroethanesulfonyl)imide, 1-propylpiperidinium bis(pentafluoroethanesulfonyl)imide, 1-pentylpiperidinium bis(pentafluoroethanesulfonyl)imide, 1,1-dimethylpiperidinium bis(pentafluoroethanesulfonyl)imide, 1-methyl-1-ethylpiperidinium bis(pentafluoroethanesulfonyl)imide, 1-methyl-1-propylpiperidinium bis(pentafluoroethanesulfonyl)imide, 1-methyl-1-butylpiperidinium bis(pentafluoroethanesulfonyl)imide, 1-methyl-1-pentylpiperidinium bis(pentafluoroethanesulfonyl)imide, 1-methyl-1-hexylpiperidinium bis(pentafluoroethanesulfonyl)imide, 1-methyl-1-heptylpiperidinium bis(pentafluoroethanesulfonyl)imide, 1-ethyl-1-propylpiperidinium bis(pentafluoroethanesulfonyl)imide, 1-ethyl-1-butylpiperidinium bis(pentafluoroethanesulfonyl)imide, 1-ethyl-1-pentylpiperidinium bis(pentafluoroethanesulfonyl)imide, 1-ethyl-1-hexylpiperidinium bis(pentafluoroethanesulfonyl)imide, 1-ethyl-1-heptylpiperidinium bis(pentafluoro ethanesulfonyl)imide, 1,1-dipropylpiperidinium bis(pentafluoroethanesulfonyl)imide, 1-propyl-1-butylpiperidinium bis(pentafluoroethanesulfonyl)imide, 1,1-dibutylpiperidinium bis(pentafluoroethanesulfonyl)imide, 2-methyl-1-pyrroline tetrafluoroborate, 1-ethyl-2-phenylindole tetrafluoroborate, 1,2-dimethylindole tetrafluoroborate, 1-ethylcarbazole tetrafluoroborate, 1-ethyl-3-methylimidazolium tetrafluoroborate, 1-ethyl-3-methylimidazolium acetate, 1-ethyl-3-methylimidazolium trifluoroacetate, 1-ethyl-3-methylimidazolium heptafluorobutyrate, 1-ethyl-3-methylimidazolium trifluoromethanesulfonate, 1-ethyl-3-methylimidazolium perfluorobutanesulfonate, 1-ethyl-3-methylimidazolium dicyanamide, 1-ethyl-3-methylimidazolium bis(trifluoromethanesulfonyl)imide, 1-ethyl-3-methylimidazolium bis(pentafluoroethanesulfonyl)imide, 1-ethyl-3-methylimidazolium tris(trifluoromethanesulfonyl)methide, 1-butyl-3-methylimidazolium tetrafluoroborate, 1-butyl-3-methylimidazolium hexafluorophosphate, 1-butyl-3-methylimidazolium trifluoroacetate, 1-butyl-3-methylimidazolium heptafluorobutyrate, 1-butyl-3-methylimidazolium trifluoromethanesulfonate, 1-butyl-3-methylimidazolium perfluorobutanesulfonate, 1-butyl-3-methylimidazolium bis(trifluoromethanesulfonyl)imide, 1-hexyl-3-methylimidazolium bromide, 1-hexyl-3-methylimidazolium chloride, 1-hexyl-3-methylimidazolium tetrafluoroborate, 1-hexyl-3-methylimidazolium hexafluorophosphate, 1-hexyl-3-methylimidazolium trifluoromethanesulfonate, 1-octyl-3-methylimidazolium tetrafluoroborate, 1-octyl-3-methylimidazolium hexafluorophosphate, 1-hexyl-2,3-dimethylimidazolium tetrafluoroborate, 1,2-dimethyl-3-propylimidazolium bis(trifluoromethanesulfonyl)imide, 1-methylpyrazolium tetrafluoroborate, 3-methylpyrazolium tetrafluoroborate, N,N-dimethyl-N-ethyl-N-propylammonium bis(trifluoromethanesulfonyl)imide, N,N-dimethyl-N-ethyl-N-butylammonium bis(trifluoromethanesulfonyl)imide, N,N-dimethyl-N-ethyl-N-pentylammonium bis(trifluoromethanesulfonyl)imide, N,N-dimethyl-N-ethyl-N-hexylammonium bis(trifluoromethanesulfonyl)imide, N,N-dimethyl-N-ethyl-N-heptylammonium bis(trifluoromethanesulfonyl)imide, N,N-dimethyl-N-ethyl-N-nonylammonium bis(trifluoromethanesulfonyl)imide, N,N-dimethyl-N,N-dipropylammonium bis(trifluoromethanesulfonyl)imide, N,N-dimethyl-N-propyl-N-butylammonium bis(trifluoromethanesulfonyl)imide, N,N-dimethyl-N-propyl-N-pentylammonium bis(trifluoromethanesulfonyl)imide, N,N-dimethyl-N-propyl-N-hexylammonium bis(trifluoromethanesulfonyl)imide, N,N-dimethyl-N-propyl-N-heptylammonium bis(trifluoromethanesulfonyl)imide, N,N-dimethyl-N-butyl-N-hexylammonium bis(trifluoromethanesulfonyl)imide, N,N-dimethyl-N-butyl-N-heptylammonium bis(trifluoromethanesulfonyl)imide, N,N-dimethyl-N-pentyl-N-hexylammonium bis(trifluoromethanesulfonyl)imide, N,N-dimethyl-N,N-dihexylammonium bis(trifluoromethanesulfonyl)imide, trimethylheptylammonium bis(trifluoromethanesulfonyl)imide, N,N-diethyl-N-methyl-N-propylammonium bis(trifluoromethanesulfonyl)imide, N,N-diethyl-N-methyl-N-pentylammonium bis(trifluoromethanesulfonyl)imide, N,N-diethyl-N-methyl-N-heptylammonium bis(trifluoromethanesulfonyl)imide, N,N-diethyl-N-propyl-N-pentylammonium bis(trifluoromethanesulfonyl)imide, triethylpropylammonium bis(trifluoromethanesulfonyl)imide, triethylpentylammonium bis(trifluoromethanesulfonyl)imide, triethylheptylammonium bis(trifluoromethanesulfonyl)imide, N,N-dipropyl-N-methyl-N-ethylammonium bis(trifluoromethanesulfonyl)imide, N,N-dipropyl-N-methyl-N-pentylammonium bis(trifluoromethanesulfonyl)imide, N,N-dipropyl-N-butyl-N-hexylammonium bis(trifluoromethanesulfonyl)imide, N,N-dipropyl-N,N-dihexylammonium bis(trifluoromethanesulfonyl)imide, N,N-dibutyl-N-methyl-N-pentylammonium bis(trifluoromethanesulfonyl)imide, N,N-dibutyl-N-methyl-N-hexylammonium bis(trifluoromethanesulfonyl)imide, trioctylmethylammonium bis(trifluoromethanesulfonyl)imide, N-methyl-N-ethyl-N-propyl-N-pentylammonium bis(trifluoromethanesulfonyl)imide, 1-butylpyridinium (trifluoromethanesulfonyl)trifluoroacetamide, 1-butyl-3-methylpyridinium (trifluoromethanesulfonyl)trifluoroacetamide, 1-ethyl-3-methylimidazolium (trifluoromethanesulfonyl)trifluoroacetamide, tetrahexylammonium bis(trifluoromethanesulfonyl)imide, diallyldimethylannmonium tetrafluoroborate, diallyldimethylannmonium trifluoromethanesulfonate, diallyldimethylannmonium bis(trifluoromethanesulfonyl)imide, diallyldimethylannmonium bis(pentafluoroethanesulfonyl)imide, N,N-diethyl-N-methyl-N-(2-methoxyethyl)ammonium tetrafluoroborate, N,N-diethyl-N-methyl-N-(2-methoxyethyl)ammonium trifluoromethanesulfonate, N,N-diethyl-N-methyl-N-(2-methoxyethyl)ammonium bis(trifluoromethanesulfonyl)imide, N,N-diethyl-N-methyl-N-(2-methoxyethyl)ammonium bis(pentafluoroethanesulfonyl)imide, glycidyltrimethylammonium trifluoromethanesulfonate, glycidyltrimethylammonium bis(trifluoromethanesulfonyl)imide, glycidyltrimethylammonium bis(pentafluoroethanesulfonyl)imide, and diallyldimethylammonium bis(pentafluoroethanesulfonyl)imide.

A method for synthesizing an ionic liquid is not particularly limited as far as an objective ionic liquid is obtained, but generally, a halide method, a hydroxide method, an acid ester method, a complexing method, and a neutralization method are used, as described in a literature "Ionic liquid -The Front Line and Future of Development-" (published by CMC Publishing Co., Ltd). A halide method, a hydroxide method, an acid ester method, a complexing method, and a neutralization method will be described below taking a method for synthesizing a nitrogen-containing onium salt as an example, but other ionic liquids such as a sulfur-containing onium salt, and a phosphorus-containing onium salt can also be obtained by the similar procedure.
Further, a commercially available ionic liquid can also be employed.

Although it is known that a pressure-sensitive adhesive layer is blended with an antistatic agent which is not liquid such as mineral salt and polymer in order to impart antistatic properties to the pressure-sensitive adhesive layer, the use of such mineral salt and polymer will cause cohesive failure in the pressure sensitive adhesive due to poor compatibility with the polymer constituting the pressure-sensitive adhesive, and will easily cause short circuit failure due to great increase in the surface resistivity after heating.

### (Elastic layer)

The elastic layer which may be arranged between the substrate and the pressure-sensitive adhesive layer has, for example, a Shore D hardness according to ASTM D 2240 of suitably about 50 or less, preferably about 40 or less, in order to achieve the followability to the surface of an adherend, expandability in the thickness direction of the thermally expandable microspheres, and the thickness uniformity of the pressure-sensitive adhesive layer, as described above.

The elastic layer is preferably formed of an organic material, and can be formed, for example, of natural rubber, synthetic rubber, or a synthetic resin having rubber elasticity.
Examples of the synthetic rubber and synthetic resin include synthetic rubber such as nitrile, diene, and acrylic rubber; thermoplastic elastomers such as polyolefin and polyester; and synthetic resins having rubber elasticity such as an ethylene-vinyl acetate copolymer, polyurethane, polybutadiene, and a plasticized polyvinyl chloride. Further, a foam containing any of the above components as the main component may be used.

Note that an essentially hard polymer such as polyvinyl chloride may also be used if it is imparted with rubber elasticity with a compounding ingredient such as a plasticizer and a softening agent.

In the present invention, the elastic layer is preferably formed of an adhesive substance. As the adhesive substance constituting the elastic layer, a similar substance to the pressure-sensitive adhesive constituting the above-described thermally expandable pressure-sensitive adhesive layer can be used. As a material constituting the elastic layer, an acrylic pressure-sensitive adhesive mainly containing an acrylic polymer as the main component can be particularly suitably used.
The thickness of the elastic layer is not particularly limited, but can be selected from the range of, for example, about 1 to 200 µm, preferably about 5 to 50 µm.

### (Another pressure-sensitive adhesive layer)

In the present invention, when the thermally expandable pressure-sensitive adhesive layer is formed only on one surface (one side) of the substrate in the heat-peelable pressure-sensitive adhesive sheet, another pressure-sensitive adhesive layer may be formed on the other surface of the substrate. An electronic part can be supported using the another pressure-sensitive adhesive layer by attaching the layer to a support such as a supporting pedestal.
The pressure-sensitive adhesives for forming such another pressure-sensitive adhesive layer are not particularly limited, and known or conventional pressure-sensitive adhesives can be used, such as pressure-sensitive adhesives illustrated as the pressure-sensitive adhesives used in the above thermally expandable pressure-sensitive adhesive layer (for example, rubber-based pressure-sensitive adhesives, acrylic pressure-sensitive adhesives, silicone pressure-sensitive adhesives, vinyl alkyl ether-based pressure-sensitive adhesives, polyester pressure-sensitive adhesives, polyamide pressure-sensitive adhesives, urethane pressure-sensitive adhesives, fluorine-based pressure-sensitive adhesives, creep characteristics-improved pressure-sensitive adhesives, and the like). Such pressure-sensitive adhesives can be used alone or in combination of two or more.

Note that the thickness of another pressure-sensitive adhesive layer may be, for example, 500 µm or less, 5 to 500 µm, preferably 10 to 300 µm, more preferably 15 to 100 µm. When forming another pressure-sensitive adhesive layer, the same methods as used for forming the thermally expandable pressure-sensitive adhesive layer (for example, a method of applying a pressure-sensitive adhesive to a substrate, a method of applying a pressure-sensitive adhesive to a separator to form a pressure-sensitive adhesive layer followed by transferring it to a substrate, and the like) can be used. Another pressure-sensitive adhesive layer may be any of a monolayer or multiple layers.

The heat-peelable pressure-sensitive adhesive sheet of the present invention can be produced by forming a thermally expandable pressure-sensitive adhesive layer optionally through other layers (such as an elastic layer) on a substrate. The heat-peelable pressure-sensitive adhesive sheet may have a form having a pressure-sensitive adhesive surface only on one side or may have a form having pressure-sensitive adhesive surfaces on both sides. Further, the heat-peelable pressure-sensitive adhesive sheet can have a form of a sheet, a tape, or the like.

### (Separator)

Although a separator is a surface provided for protecting the pressure-sensitive adhesive surface of the thermally expandable pressure-sensitive adhesive layer, it may be used for providing uneven parts on the surface of the thermally expandable pressure-sensitive adhesive layer as described above. For example, there can be used a substrate having a peeling layer of a plastic film, paper or the like which is surface-treated with a release agent such as a silicone-based, a long-chain alkyl-based, a fluorine-based, or a molybdenum sulfide release agent; a low-adhesive substrate composed of a fluorine-based polymer, such as polytetrafluoroethylene, polychlorotrifluoroethylene, polyvinyl fluoride, polyvinylidene fluoride, a tetrafluoroethylene-hexafluoropropylene copolymer, and a chlorofluoroethylene-vinylidene fluoride copolymer; and a low-adhesive substrate composed of a nonpolar polymer, such as olefinic resins (for example, polyethylene, polypropylene, and the like). Note that the separator can also be used as a substrate for supporting the thermally expandable pressure-sensitive adhesive layer.
Note that the separator can be formed by a known method. Further, the thickness of the separator is not particularly limited.

The electronic parts which are the targets of using the pressure-sensitive adhesive tape for temporary fixing of electronic parts of the present invention include all the parts used in electronic work, electronic engineering, electrical engineering, and the like and all the parts constituting electronic equipment, which may be formed from a semiconductor, an electric conductor and/or an insulating material, or a combination thereof. Examples thereof include active components (for example, a transistor, IC, LSI, VLSI, a diode, a light emitting diode, laser, a thyristor, a 3-terminal regulator, an image sensor, an electron tube, a vacuum tube, a traveling-wave tube, a cathode-ray tube, a magnetron, and the like, which are mainly formed from a semiconductor), passive components (for example, a resistor, a capacitor, a loudspeaker, a coil, a potential transformer, a transformer, a relay, a piezoelectric element, a quartz resonator, a ceramic radiator, a varistor, and the like), structural parts (a wiring part, a printed circuit board, a connector, a switch, an electric wire, an insulator, a terminal, and the like), and electronic equipment containing these electronic parts (for example, a display unit, lighting equipment, an analytical instrument, communication equipment, medical equipment, broadcast equipment, and the like).
More specifically, there are illustrated a step of forming an internal electrode pattern of electronic parts such as a ceramic capacitor, a step of forming a pattern on a semiconductor wafer, a step of forming a pattern on a circuit board, various pattern-forming steps required for a display unit, and the like.

### (Use of the pressure-sensitive adhesive tape for temporary fixing of electronic parts)

Thus, the heat-peelable pressure-sensitive adhesive sheet of the present invention can be suitably used as a heat-peelable pressure-sensitive adhesive sheet used when an adherend is processed. That is, the heat-peelable pressure-sensitive adhesive sheet of the present invention can be suitably used in applications in which it can adhere to an adherend (workpiece) with a strong adhesive strength during processing, and the adhesion state can be quickly released after processing. Use of the heat-peelable pressure-sensitive adhesive sheet allows easy and quick peeling after processing while suppressing or preventing contamination of an adherend, allowing manufacturing workability to be greatly improved.

Note that such a method of processing an adherend can be arbitrarily select. Examples thereof include processing such as cutting (such as grinding treatment and dicing), electrode printing on a green sheet (such as pattern forming), and assembly, as well as processing in a lamination step, a pressurizing step, and a firing step.

Note that heat treatment at the time of peeling or separating the heat-peelable pressure-sensitive adhesive sheet from an adherend (workpiece) can be performed using a suitable heating means such as a hot plate, a hot air dryer, a near-infrared lamp, and an air dryer. The heating temperature may be a thermal expansion starting temperature (foaming starting temperature) of surface-treated thermally expandable microspheres in the thermally expandable pressure-sensitive adhesive layer or higher. However, the conditions of heat treatment can be arbitrarily set depending on reduction in the bonding area due to the surface state of an adherend, the type of surface-treated thermally expandable microspheres and the like, heat resistance of a substrate or an adherend, heating methods (such as heat capacity, heating means), and the like. A general heating condition includes a temperature of 100 to 250°C and a duration of 5 to 90 seconds (for a hot plate and the like) or for 5 to 15 minutes (for a hot air dryer and the like). In these heating conditions, the surface-treated thermally expandable microspheres in the thermally expandable pressure-sensitive adhesive layer usually expand and/or foam to expand and deform the thermally expandable pressure-sensitive adhesive layer to unevenly deform it, leading to reduction or loss of adhesive strength. Note that the heat treatment can be performed in a suitable stage depending on the purpose of use. Further, an infrared lamp and heated water may also be used as a heat source.

The heat-peelable pressure-sensitive adhesive sheet of the present invention can also be used as a protective material for conveying an adherend.

The present invention will be described in more detail below based on Examples, but the present invention is not limited at all by these Examples.

### [Examples and Comparative Examples]

### Example 1

A coating liquid was obtained by uniformly mixing and dissolving 100 parts of a copolymer of ethyl acrylate/2-ethylhexyl acrylate/acrylic acid (60 parts/40 parts/3 parts), 1.0 part of an epoxy crosslinking agent as a crosslinking agent, 5 parts of 1-butyl-3-methylpyridinium bisimide (trade name: CIL-312, manufactured by Japan Carlit Co., Ltd.) as an electrostatic discharge agent, 15 parts of a rosin phenol tackifier, 30 parts of thermally expandable microspheres of a 150°C foaming-expansion type (Matsumoto Microsphere F-80SD, manufactured by Matsumoto Yushi-Seiyaku Co., Ltd), and toluene. The resulting coating liquid was applied to a supporting substrate (PET#100) so that the thickness after drying will be 50 µm and dried to obtain a pressure-sensitive adhesive tape for temporary fixing of electronic parts 1.

### Example 2

A sheet 2 was obtained in the same manner as in Example 1 except that the electrostatic discharge agent was added in an amount of 0.1 part.

### Example 3

A sheet 3 was obtained in the same manner as in Example 1 except that the electrostatic discharge agent was added in an amount of 10 parts.

### Example 4

A sheet 4 was obtained in the same manner as in Example 1 except that an antistatic PET (Diafoil T-100G, manufactured by Mitsubishi Plastics, Inc.) was used as a supporting substrate.

### Comparative Example 1

A sheet 5 was obtained in the same manner as in Example 1 except that an electrostatic discharge agent was not added.

### Comparative Example 2

A sheet 6 was obtained in the same manner as in Example 1 except that the electrostatic discharge agent was added in an amount of 0.001 part.

### Comparative Example 3

A sheet 7 was obtained in the same manner as in Example 1 except that the electrostatic discharge agent was added in an amount of 20 parts.

### Comparative Example 4

A sheet 8 was obtained in the same manner as in Example 1 except that lithium perchlorate was added as an electrostatic discharge agent.

### Comparative Example 5

A sheet 9 was obtained in the same manner as in Example 1 except that a quaternary ammonium acrylate copolymer was added as an electrostatic discharge agent.

Tables 1 and 2 show evaluation results of short circuit failure evaluation, 23°C adhesion, and staining of heat-peelable pressure-sensitive adhesive sheets 1 to 9 produced in Examples 1 to 4 and Comparative Examples 1 to 5.

### ◆ Evaluation of short circuit failure and evaluation of fraction defective of force-cutting

As shown in Figure 2, a laminated ceramic sheet 3 (size: 100 mm × 100 mm × 2 mm in thickness) was attached (temporarily fixed) to the thermally expandable pressure-sensitive adhesive layer of the pressure-sensitive adhesive tape for temporary fixing of electronic parts 1 and fixed to a support 2. Then, the sheet was fully cut (subjected to cutting treatment by force-cutting) into chips each having a size of 0.6 mm × 0.3 mm through a force-cutting blade 4 and then peeled from the pressure-sensitive adhesive tape for temporary fixing of electronic parts by foaming thereof in an oven heated to 160°C, thus recovering the chips cut into small pieces. The fraction defective defined by the number of chips having a short circuit failure by static electricity in 100 pieces of the recovered chips was shown in %.
Further, cutting accuracy at the force-cutting (whether the adherend has been cut at the right angle or the like) was microscopically observed, and the fraction defective was shown in %.

### ◆ 23°C Adhesion (N/20 mm)

The produced sample of the pressure-sensitive adhesive tape for temporary fixing of electronic parts was cut into a width of 20 mm and a length of 140 mm, to which was laminated an adherend: PET #25 (30 mm in width) according to JIS Z 0237, and the resulting laminate was allowed to stand for about 30 minutes. Subsequently, 23°C adhesion was obtained by measuring a load when the adherend: PET was peeled at a peel angle of 180° and a peel rate of 300 mm/min at a temperature of 23°C.

### ◆ Measurement of surface resistivity of pressure-sensitive adhesive and measurement of ratio of surface resistance after heating relative to that before heating

The produced sample of the pressure-sensitive adhesive tape for temporary fixing of electronic parts was cut into a width of 50 mm and a length of 150 mm, which was measured for the level of the surface resistance of the pressure-sensitive adhesive after releasing the separator (in a 23°C/50% atmosphere). In addition, the above sample was subjected to heat foaming on a hot plate previously heated to 160°C, and then the level of the surface resistance of the pressure-sensitive adhesives was measured in the same manner (in a 23°C/50% atmosphere) to calculate the ratio thereof after heating relative to that before heating.

**[Table 1]**

| Evaluation results of pressure-sensitive adhesive tape for temporary fixing of electronic parts | | | | | |
|---|---|---|---|---|---|
| | Evaluation of short circuit failure | Adhesion (N/20mm) | Fraction defective of force-cutting | Surface resistivity value before heating (Ω/□) | Ratio of surface resistance after heating relative to that before heating |
| Example 1 | 0% | 5.00 | 0% | 3.48 × 10¹⁰ | 3.1 |
| Example 2 | 0% | 4.83 | 0% | 8.27 × 10¹¹ | 2.4 |
| Example 3 | 0% | 5.23 | 0% | 7.81 × 10⁹ | 2.8 |
| Example 4 | 0% | 5.13 | 0% | 8.14 × 10⁹ | 2.5 |
| Comparative Example 1 | 20% | 4.98 | 0% | OVER | - |
| Comparative Example 2 | 5% | 5.10 | 0% | 4.37 × 10¹³ | - |
| Comparative Example 3 | 0% | 5.78 | 10% | 8.93 × 10⁸ | 3.7 |
| Comparative Example 4 | 10% | 10.46 | 0% | 9.13 × 10¹¹ | 8.3 |
| Comparative Example 5 | 10% | 5.22 | 0% | 6.11 × 10¹¹ | 9.4 |

Examples 1 to 4 showed that the ratio of the surface resistance after heating relative to that before heating was 5 or less, and the electronic parts were able to be produced without causing short circuit failure due to the increase in surface resistivity and without short circuit failure due to heat peeling and failure at the force-cutting. The tendency of reduction in the surface resistance values in proportion to the amount of the ionic liquid added was verified, and reduction in the surface resistance values by using a substrate which is subjected to antistatic treatment was also verified.
Failure by force-cutting did not occur in Comparative Examples 1 and 2, but since the electrostatic discharge agent was not mixed in the case of Comparative Example 1 and the amount of the electrostatic discharge agent added was small in the case of Comparative Example 2, the ratio of the surface resistance after heating relative to that before heating was large and the removal of electricity was not sufficient at the heat peeling, thus causing short circuit failure.
The electrostatic discharge agent was excessively added in the case of Comparative Example 3, wherein the ratio of the surface resistance after heating relative to that before heating was 5 or less. However, the increase in the fraction defective due to the reduction in the force-cutting accuracy was verified, which was due to the reduction in elastic modulus probably caused by the increase in the liquid component in the pressure-sensitive adhesive.
In Comparative Example 4, there was observed cohesive failure in the pressure-sensitive adhesive during the measurement of adhesion that is probably caused by the low compatibility between the electrostatic discharge agent added and the pressure-sensitive adhesive, which not only prevented stable adhesion measurement, but produced short circuit failure because the ratio of the surface resistance after heating relative to that before heating was large.
The ionic liquid was not used in Comparative Example 5. As a result, although the surface resistance value before heating was small, short circuit failure occurred because the ratio of the surface resistance after heating relative to that before heating was large, similar to the results in Comparative Example 4.
These results are summarized as follows. When electronic parts are processed using a pressure-sensitive adhesive tape for temporary fixing of electronic parts which is provided with a thermally expandable pressure-sensitive adhesive layer, the pressure-sensitive adhesive tape for temporary fixing of electronic parts will be easily peeled from the electronic parts due to the reduction in the adhesion by heat foaming. However, when the thermally expandable pressure-sensitive adhesive layer does not contain an electrostatic discharge agent or contains only a small amount thereof, static electricity will accumulate and short circuit failure will occur because the surface resistance value is naturally high both before and after heating and the static electricity is not removed from the electronic parts.
An electrostatic discharge agent composed of an inorganic compound or a polymer which is not liquid was added to the pressure-sensitive adhesives in order to solve such a problem. However, the same results was obtained as in the case where no electrostatic discharge agent was added in that short circuit failure still occurred due to the accumulation of static electricity.
The present invention was able to obtain a pressure-sensitive adhesive tape for temporary fixing of electronic parts useful for temporary fixing of electronic parts for the first time by selecting an ionic liquid as an electrostatic discharge agent and setting the content ratio thereof in a pressure-sensitive adhesive within a specific range.

### Description of Symbols

- 1 ...: Pressure-sensitive adhesive tape for temporary fixing of electronic parts
- 2 ...: Support
- 3 ...: Laminated ceramic sheet
- 4 ...: Force-cutting edge

## Claims

1. A pressure-sensitive adhesive tape for temporary fixing of electronic parts comprising at least a supporting substrate film and a thermally expandable pressure-sensitive adhesive layer provided on one side of the substrate, wherein the thermally expandable pressure-sensitive adhesive layer contains thermally expandable microspheres and an ionic liquid; the content of the ionic liquid is 0.01 to 10 parts by weight based on 100 parts by weight of a polymer contained in the thermally expandable pressure-sensitive adhesive layer; the surface resistance of the thermally expandable pressure-sensitive adhesive layer is 1.0 × 10¹³ Ω/□ or less; and the ratio of the surface resistance after heating for foaming to that before the heating is 5.0 or less.

2. The pressure-sensitive adhesive tape for temporary fixing of electronic parts according to claim 1, wherein the pressure-sensitive adhesive tape for temporary fixing of electronic parts has a 180° peeling adhesion to an adherend PET of 0.2 to 20 N/20 mm.

3. The pressure-sensitive adhesive tape for temporary fixing of electronic parts according to claim 1 or 2, wherein the back of the substrate is subjected to antistatic treatment.
